(19) **Europäisches Patentamt / European Patent Office / Office européen des brevets**

(11) **EP 4 704 340 A2**

(12) # EUROPEAN PATENT APPLICATION

(43) Date of publication:
04.03.2026 Bulletin 2026/10

(21) Application number: 25199621.1

(22) Date of filing: 02.09.2025

(51) International Patent Classification (IPC):
**H03H 7/01** (2006.01)      **H03H 7/38** (2006.01)
**H03H 7/48** (2006.01)

(52) Cooperative Patent Classification (CPC):
**H03H 7/48; H03H 7/0115; H03H 7/0153;**
**H03H 7/1733; H03H 7/38;** H03H 2007/386;
H03H 2210/025; H03H 2210/028; H03H 2210/033

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: 03.09.2024 US 202418822971

(71) Applicant: NXP USA, Inc.
Austin, TX 78735 (US)

(72) Inventors:
• YANG, Xin
5656AG Eindhoven (NL)
• ACAR, Mustafa
5656AG Eindhoven (NL)
• HOOGZAAD, Gian
5656AG Eindhoven (NL)
• PIJL-PEETERS, Jasper
5656AG Eindhoven (NL)

(74) Representative: Hardingham, Christopher Mark
NXP Semiconductors
Intellectual Property Group
The Cattle Barn
Upper Ashfield Farm, Hoe Lane
Romsey, Hampshire S051 9NJ (GB)

(54) **CONFIGURABLE UNEQUAL POWER DIVIDER/COMBINER CIRCUITS AND METHODS**

(57)   A power divider/combiner circuit may include a first port configured to receive a signal, a second port, and a third port. The circuit may include an unequal Wilkinson power divider/combiner circuit including a first node coupled to the first port, a second node coupled to the second port, and a third node. The unequal Wilkinson power divider/combiner circuit is configured to receive a signal at the first node and divide the signal to produce a first signal at the second node and a second signal at the third node. The circuit may include a configurable impedance transformation circuit coupled between the third node and the third port. The configurable impedance circuit is configured to provide a configurable phase shift and a configurable attenuation of the second signal to provide a selected power division ratio between the first signal at the second port and the second signal at the third port.

FIG. 6

EP 4 704 340 A2

**Description**

FIELD OF USE

The present disclosure generally relates to power divider/combiner circuits, and more particularly to configurable or programmable unequal power divider/combiner circuits and methods that may be used in conjunction with other circuitry, such as a Doherty amplifier.

BACKGROUND

Power dividers (or power splitters) may be configured to receive an input signal at a first port and may be configured to couple a first portion of electromagnetic power from the input signal to a first port and a second portion of the electromagnetic power from the input signal to a second port, enabling the electromagnetic power to be used by other circuitry. Power dividers are frequently used in radio frequency transmitters and receivers.

BRIEF DESCRIPTION OF THE DRAWINGS

The detailed description is set forth with reference to the accompanying figures. In the figures, the left-most digit(s) of a reference number identifies the figure in which the reference number first appears. The use of the same reference numbers in different figures and in the detailed description indicates similar or identical items or features.

FIG. 1A depicts a diagram of a circuit including a programmable power divider/combiner circuit configured to deliver power according to a pre-determined power ratio and phase to output ports coupled to peaking and main or carrier amplifiers of a Doherty amplifier, in accordance with certain embodiments.

FIG. 1B depicts a diagram of a circuit including a programmable power divider/combiner circuit configured to deliver power according to a pre-determined power ratio and phase to output ports coupled to peaking and main or carrier amplifiers of an inverted Doherty amplifier, in accordance with certain embodiments.

FIG. 2 depicts a block diagram of a configurable unequal power divider/combiner circuit that can be used in the circuits of FIGs. 1A and 1B, in accordance with certain embodiments.

FIG. 3A depicts a low-pass unequal power divider/combiner circuit with a parallel resistor-capacitor isolation network, in accordance with certain embodiments.

FIG. 3B depicts a low-pass unequal power divider/combiner circuit with a series resistor-capacitor isolation network, in accordance with certain embodiments.

FIG. 4A depicts a high-pass unequal power divider/combiner circuit with a parallel resistor-inductor isolation network, in accordance with certain embodiments.

FIG. 4B depicts a high-pass unequal power divider/combiner circuit with a series resistor-inductor isolation network, in accordance with certain embodiments.

FIG. 5A depicts a diagram of a low-pass unequal power divider/combiner circuit including a plurality of inductor-capacitor branches, in accordance with certain embodiments.

FIG. 5B depicts a diagram of a capacitive isolation network, in accordance with certain embodiments.

FIG. 5C depicts a diagram of a resistive isolation network, in accordance with certain embodiments.

FIG. 6 depicts a diagram of an embodiment of the configurable unequal power divider/combiner circuit of FIG. 2 including configurable impedance transformation circuits to provide a positive phase difference between output ports that is suitable for the inverted Doherty power amplifier of FIG. 1B.

FIG. 7 depicts a diagram of an embodiment of the configurable unequal power divider/combiner circuit of FIG. 2 including configurable impedance transformation circuits to provide a negative phase difference between output ports that is suitable for the Doherty power amplifier of FIG. 1A.

FIG. 8 depicts a diagram of an embodiment of the configurable unequal power divider/combiner circuit of FIG. 2 including a configurable impedance transformation circuit in one of the output paths to provide a positive phase difference between output ports that is suitable for the inverted Doherty power amplifier of FIG. 1B.

FIG. 9 depicts a diagram of an embodiment of the configurable unequal power divider/combiner circuit of FIG. 2 including a configurable impedance transformation circuit in one of the output paths to provide a negative phase difference between output ports that is suitable for the Doherty power amplifier of FIG. 1A.

FIG. 10 depicts a flow diagram of a method of dividing power of an input signal using a configurable unequal power divider/combiner circuit to produce output signals having a selected power ratio and a selected phase difference, in accordance with certain embodiments.

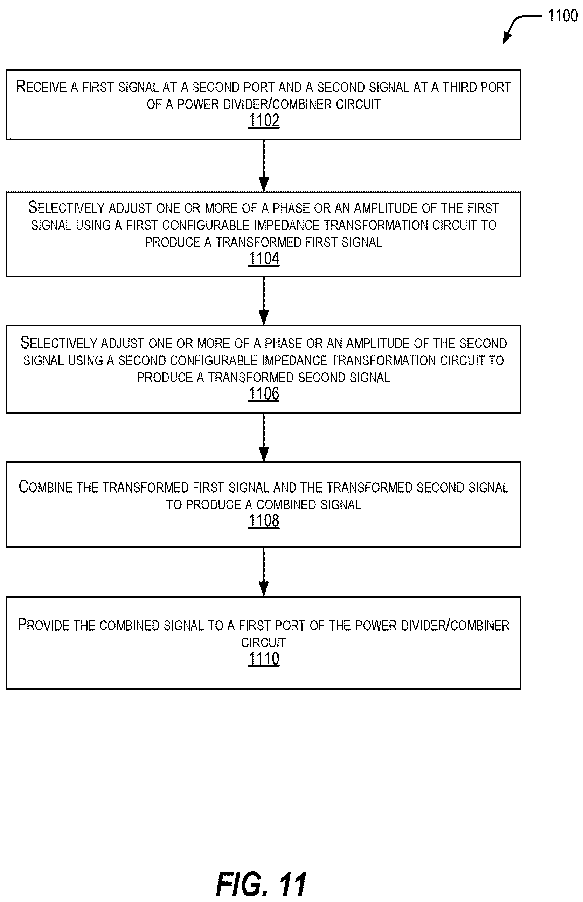

FIG. 11 depicts a flow diagram of a method of combining a first signal and a second signal using a configurable unequal power divider/combiner circuit to produce a combined signal, in accordance with certain embodiments.

While implementations are described in this disclosure by way of example, those skilled in the art will recognize that the implementations are not limited to the examples or figures described. Rather, the figures and detailed description thereto are not intended to limit implementations to the form disclosed, but instead the intention is to cover all modifications, equivalents, and alternatives falling within the scope as defined by the appended claims. The headings used in this disclosure are for organizational purposes only and are not meant to limit the scope of the description or the claims. As used throughout this application, the word "may" is used in a permissive sense (in other words, the term "may" is intended to mean "having the potential to") instead of in a mandatory sense (as in "must"). Similarly, the terms "include," "including," and "includes" mean "including, but not limited to."

DETAILED DESCRIPTION

Embodiments of circuits and methods are described below that may be configured to provide a low-loss, programmable (configurable or reconfigurable) unequal radio frequency (RF) power divider or combiner. The power divider or combiner may include a programmable circuit to provide configurable phase control and amplitude control in one or more of the two output signal paths. In one or more embodiments, the programmable circuit may be included in the output signal path that has the lowest output power. In one or more embodiments, the programmable circuit may include switched shunt capacitors and resistors, enabling the use of relatively low-quality and low-cost RF switches.

In one or more embodiments, the programmable unequal RF power divider or combiner may be configured to receive an RF signal at a first port and to divide the electromagnetic power of the RF signal into a first signal and a second signal, which may be provided to first and second signal paths, respectively. The power ratio between the first signal and the second signal may be configurable to provide a selected power ratio, which may enable tuning to cope with modelling inaccuracy and process and assembly spread. Additionally, the programmable power ratio may enable adaptation of the power divider or combiner to signals with varying peak-to-average ratios (PAR), e.g., a PAR of 7.5 decibels (dB) to 9 dB for load modulated power amplifier applications such as Doherty power amplifiers.

In one or more embodiments, the programmable unequal RF power divider or combiner may include one or more configurable impedance transformation circuits. In one or more embodiments, one of the configurable impedance transformation circuits may be provided in a signal path from a first output of the power divider or combiner to a port, which may be coupled to another circuit, such as a main or carrier amplifier of a Doherty power amplifier. In one or more embodiments, one of the configurable impedance transformation circuits may be provided in a signal path from a second output of the power divider or combiner to a port, which may be coupled to another circuit, such as a peaking amplifier of a Doherty power amplifier. The one or more configurable impedance transformation circuits may be programmable to provide a selected phase shift and a selected attenuation. In one or more embodiments, a first configurable impedance transformation circuit may include a series inductor and a parallel capacitor (low pass configuration) and a second configurable impedance transformation circuit may include a series capacitor and a parallel inductor (high pass configuration). In one or more embodiments, a low-pass or a high-pass configuration of the configurable impedance transformation circuit may be provided between one of the outputs of the power divider and one of the ports and the other output of the power divider may be connected to a different port.

In the following discussion, the programmable unequal RF power divider or combiner circuit is discussed with respect to its power divider functionality in which a first signal is received a first node and is divided into a second signal and a third signal. The second signal optionally is provided to a first configurable impedance transformation circuit to produce a transformed second signal at the second node and the third signal is provided to a second configurable impedance transformation circuit to produce a transformed third signal at the third node, where the second signal and the third signal differ by a selected power division ratio. However, it should be appreciated that the programmable unequal RF power divider or combiner circuit may also operate in reverse where a second signal is received at the second node and a third signal is received at the third node. In this combiner example, the second signal optionally may be provided to the first configurable impedance transformation circuit to produce a transformed second signal and the third signal is provided to the second configurable impedance transformation circuit to produce a transformed third signal. The transformed second and third signals are combined to produce a first signal. Since the operation of the combiner functionality can be readily understood by one of skill in the art, for simplicity, the following discussion is largely directed to the divider functionality.

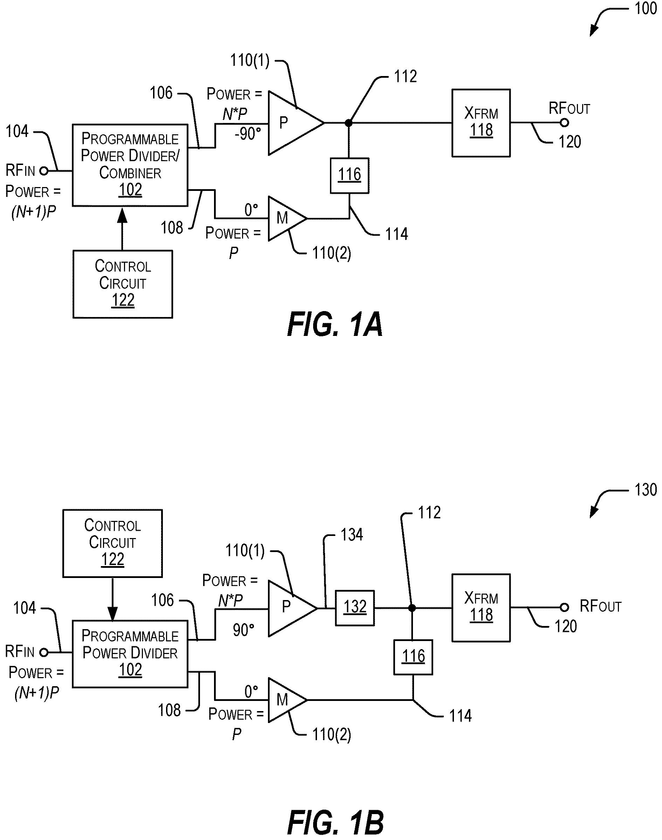

The programmable unequal RF power divider or combiner circuit may be implemented in a variety of circuits. In one or more embodiments, the programmable unequal RF power divider or combiner circuit may be used to provide a selected power ratio between a first port coupled to a peaking amplifier and a second port coupled to a main or carrier amplifier of a Doherty power amplifier circuit. Examples of Doherty power amplifier circuits are described below with respect to FIGs. 1A and 1B.

FIG. 1A depicts a diagram of an amplifier circuit 100 including a programmable unequal power divider/combiner circuit 102 configured to deliver power according to a pre-determined power ratio and phase to output ports 106 and 108 coupled to a peaking amplifier 110(1) and a main or carrier amplifier 110(2), respectively, of a Doherty power amplifier, in accordance with certain embodiments. In one or more embodiments, the programmable unequal power divider/combiner circuit 102 may also be configured to combine signals received from the ports 106 and 108 and to provide the combined signal to the port 104.

In this example, a radio frequency (RF) signal $RF_{IN}$ may be received at a port 104 coupled to a programmable unequal power divider/combiner circuit 102. The programmable unequal power divider/combiner circuit 102 may be configured to divide the electromagnetic power of the RF signal $RF_{IN}$ according to a pre-determined power division ratio. In an example, the pre-determined power division ratio may cause the programmable unequal power divider/combiner circuit 102 to divide the power $(N+1)P$ of the RF signal $RF_{IN}$ to produce a first signal at a port 106 having a first power $N*P$ and a second signal at a port 108 having a second power $P$. The first signal may be a positive ninety degrees (90°) out of phase with the second signal at the port 108.

The port 106 may be coupled to an input of a first (peaking) amplifier 110(1), which may include an output coupled to a node 112. The first amplifier 110(1) may be configured provide an amplified version of the first signal to the node 112. The port 108 may be coupled to an input of a second (main) amplifier 110(2), which may include an output coupled to a node 114. The second amplifier 110(2) may be configured to provide an amplified version of the second signal to the node 114.

In the illustrated embodiment, the first signal provided to the peaking amplifier 110(1) lags the phase of the RF signal provided to the main (carrier) amplifier 110(2) via the port 108 by about ninety degrees (90°). The amplifier circuit 100 may include an impedance inversion element 116 coupled between the node 112 and the node 114. The impedance inversion element 116 may be configured so that the amplified carrier signal (at the node 114) and amplified peaking signal at the node 112 arrive in phase with each other at the node 112 (power combining node). For example, the impedance inversion element 116 may include a lambda divided by four (λ/4) transmission line phase shift element (e.g., a microstrip line), which may impart about a ninety-degree (90°) phase shift relative to the second signal after amplification by the carrier amplifier 110(2). Accordingly, the amplified second signal and the amplified first signal combine in phase at the combining node 112.

In one or more embodiments, to provide a 90 degree phase shift and an impedance inversion between a drain terminal of the main or carrier amplifier 110(2) and the combining node 112 (e.g., at a drain terminal of the peaking amplifier final-stage transistor 110(1)), the drain terminal of the transistor of the final-stage carrier amplifier 110(2) is electrically coupled to the first end of an embodiment of the impedance inversion element 116, and the second end of the impedance inversion element 116 is electrically coupled to the drain terminal of the transistor of the final-stage peaking amplifier 110(1), which is coupled to or which forms the node 112 (i.e., the combining node 112). The electrical length of the impedance inversion element 116 between the drain terminals of the carrier amplifier 110(2) and the peaking amplifier 110(1) may be determined by the parasitic drain-source capacitances of the transistors of the carrier amplifier 110(2) and the peaking amplifier 110(1), the electrical length of an impedance inverter line (e.g., a transmission line) extending between the transistor drain terminals of the carrier amplifier 110(2) and the peaking amplifier 110(1), and the electrical lengths of any additional series conductive structures between the drain terminals and the ends of the impedance inverter line.

In one or more embodiments, the amplifier circuit 100 may be configured so that the signal path that includes the carrier amplifier 110(2) provides amplification for relatively low-level input signals, and both the carrier amplifier 110(2) and the peaking amplifier 110(1) operate in combination to provide amplification for relatively high-level input signals. This amplifier configuration may be accomplished, for example, by biasing the carrier amplifier 110(2) to operate in a class AB mode, and by biasing the peaking amplifier 110(1) to operate in a class C mode.

In one or more embodiments, the programmable unequal power divider/combiner circuit 102 may be configurable to alter the power ratio of the first signal provided to the peaking amplifier 110(1) relative to the second signal provided to the carrier or main amplifier 110(2). In one or more embodiments, the programmable unequal power divide/combiner r circuit 102 may be configured to receive one or more control signals from a control circuit 122, which may configure the power division provided by the programmable unequal power divider/combiner circuit 102. While the example provided in FIG. 1A is directed to a non-inverting amplifier configuration, the programmable unequal power divider/combiner circuit 102 may also be used in connection with an inverting amplifier configuration. An example of an inverted Doherty amplifier is described below with respect to FIG. 1B, in which the second signal provided to the carrier amplifier 110(2) lags the first signal provided to the peaking amplifier 110(1) by about ninety degrees (90°).

FIG. 1B depicts a diagram of an amplifier circuit 130 including a programmable power divider/combiner circuit 102 configured to deliver power according to a pre-determined power ratio and phase to output ports coupled to a peaking amplifier 110(1) and a main or carrier amplifier 110(2) of an inverted Doherty power amplifier, in accordance with certain embodiments. As previously mentioned, the programmable power divider/combiner circuit 104 may also be configured to combine signals received at the ports 106 and 108 and to provide the combined signal to the port 104. The amplifier circuit 120 has all the elements of the amplifier circuit 100 in FIG. 1A and has an impedance inversion element 132 coupled between a node 134 coupled to the output of the peaking amplifier 110(1) and the combining node 112. The impedance inversion element 132 may be configured to provide a half-wavelength ($\lambda$/2) phase shift.

In the illustrated embodiment, the first signal at the port 106 may be a positive ninety degrees (90°) out of phase with the second signal at the port 108. In this inverting implementation, the second signal may lag the first signal in terms of phase. The impedance inversion elements 116 and 132 may adjust the phase of the amplified versions of the first and second signals such that the amplified signals arrive at the combining node 112 in phase.

In one or more embodiments, the programmable unequal power divider/combiner circuit 102 may be configured to enable adjustment of the power ratio between the first signal provided to the peaking amplifier 110(1) and the second signal provided to the carrier (or main) amplifier 110(2). In one or more embodiments, the phase difference between the first signal and the second signal may also be adjustable (tunable or reconfigurable). The power ratio tuning and phase difference tuning capabilities of the programmable unequal power divider/combiner circuit 102 may enable adjustability to cope with modeling inaccuracies as well as spread of process and assembly, which might otherwise adversely impact the power of the output signal from the amplifier circuit 100 or the amplifier circuit 130. Additionally, the power ratio tuning and phase difference tuning may enable adaptation to signals with varying peak-to-average ratios (PAR), for example, for signals having a PAR within a range from 7.5 dB to 9 dB for load-modulated power amplifier applications, such as Doherty power amplifiers.

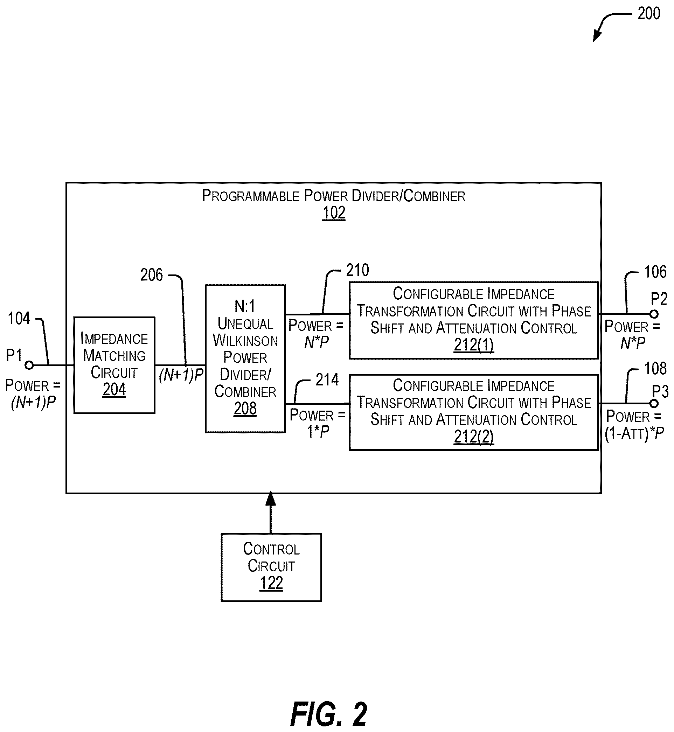

FIG. 2 depicts a block diagram of a circuit 200 including a configurable (programmable) unequal power divider/combiner circuit 102 that can be used in the amplifier circuit 100 or the amplifier circuit 130 of FIGs. 1A and 1B, in accordance with certain embodiments. Typically, the port 104 may have a relatively high Ohmic interface impedance, while the port (P2) 106 and the port (P3) 108 have relatively low Ohmic interface impedance. In one or more embodiments, the programmable unequal power divider/combiner circuit 102 may include an impedance matching circuit 204 including an input coupled to the port (P1) 104 and an output coupled to a node 206. The impedance matching circuit 204 may be configured to present an input impedance configured to match the impedance of a transmission line coupled to the port (P1) 104 to improve frequency bandwidth and insertion loss characteristics of the programmable unequal power divider/combiner circuit 102. The port 104 may be configured to receive a radio frequency (RF) input signal with an input power ($Power = (N+1)*P$) and to provide the received RF input signal with the input power to the node 206. In one or more embodiments, the impedance matching circuit 204 may be omitted, and the port 104 may be coupled to the node 206 to provide the RF input signal.

The programmable unequal power divider/combiner circuit 102 may include an unequal Wilkinson power divider 208 including an input coupled to the node 206, a first output coupled to a node 210, and a second output coupled to a node 214. In an embodiment in which the impedance matching circuit 204 is omitted, the input of the unequal Wilkinson power divider/combiner circuit 208 may be coupled to the port 104. In one or more embodiments, the programmable unequal Wilkinson power divider/combiner circuit 102 may include an inductor-capacitor implementation providing high-pass output signals to the nodes 210 and 214 or may include a capacitor-inductor implementation providing low-pass output signals to the nodes 210 and 214. In one or more embodiments, the unequal Wilkinson power divider/combiner circuit 208 may be configured to receive the RF input signal at the node 206 and to divide the power of the RF input signal according to a pre-determined power divide ratio (N:1) to produce a first signal having a first power $N*P$ at the node 210 and to produce a second signal having a second power P at the node 214.

In one or more embodiments, the programmable unequal power divider/combiner circuit 102 may include one or more of a first configurable impedance transformation circuit 212(1) with phase shift and attenuation control and a second configurable impedance transformation circuit 212(2) with phase shift and attenuation control. The first configurable impedance transformation circuit 212(1) may include an input coupled to the node 210 and an output coupled to the port 106. The second configurable impedance transformation circuit 212(2) may include an input coupled to the node 214 and an output coupled to the port 108. In one or more embodiments, the first configurable impedance transformation circuit 212(1) may be omitted, and the second configurable impedance transformation circuit 212(2) may be included, reducing the overall loss. In one or more embodiments, the first configurable impedance transformation circuit 212(1) may be omitted or may be configured to present no impedance transformation between the node 210 and the port 106 such that the power $N*P$ of the first signal at the node 210 is equal to the power $N*P$ at the port 106. The second configurable impedance transformation circuit 212(2) may be configured to provide a selected attenuation and phase shift to the second signal at the node 214 such that the power $P$ of the first signal is attenuated to produce an output signal at the port 108 having a power level that may be determined according to the following equation:

$$Power_{P3} = (1 - ATT) * P. \tag{1}$$

where the variable $ATT$ represents the attenuation presented by the second configurable impedance circuit 212(2). In this example, the power division ratio between the port 106 and the port 108 may be determined as follows:

$$\text{Power}_{\text{Ratio}} = \frac{N}{(1-ATT)}. \tag{2}$$

In one or more embodiments, the programmable unequal power divider/combiner circuit 102 may be configured to receive control signals from the control circuit 122. The programmable unequal power divider/combiner circuit 102 may be configured to adjust one or more of the power division ratio of the unequal Wilkinson power divider/combiner circuit 208, the phase shift provided by the configurable impedance transformation circuit 212(1), the attenuation provided by the configurable impedance transformation circuit 212(1), the phase shift provided by the configurable impedance transformation circuit 212(2), or the attenuation provided by the configurable impedance transformation circuit 212(2).

In an illustrative, non-limiting embodiment, the unequal Wilkinson power divider/combiner circuit 208 is configured to have a ratio of 1.6 (i.e, N=1.6) and the configurable impedance transformation circuit 212(2) may be programmed to control the power level at the node (P3) 108. In one or more embodiments, the programmable unequal power divider/combiner circuit 102 may be used in connection with a Doherty power amplifier in which the node (P2) 106 may be coupled to the peaking amplifier 110(1) and the node (P3) 108 may be coupled to the main or carrier amplifier 110(2). The power difference between the node (P2) 106 and the node (P3) 108 may be configured from approximately two decibels (2 dB) to a selected difference that is greater than 2 dB.

In the illustrated embodiment, it should be understood that the signals at the nodes 210 and 214 have the same phase. A phase shift of about ninety degrees (90°) may be added using one or more of the configurable impedance transformation circuit 212(1) or the configurable impedance transformation circuit 212(2). In one or more embodiments, both of the configurable impedance transformation circuits 212(1) and 212(2) may be used to add the phase shift, for example, by adding a positive phase shift in one and by adding a negative phase shift in the other. In one or more embodiments, the configurable impedance transformation circuit 212(1) may be implemented with a high-pass filter (series capacitor, parallel inductor) in the direction of the node (P2) 106 to the node (P1) 104, and the configurable impedance transformation circuit 212(2) may be implemented with a low-pass filter (series inductor, parallel capacitor) in the direction of the node (P3) 108 to the node (P1) 104, or vice versa.

In one or more embodiments, the unequal Wilkinson power divider/combiner circuit 208 may have a fixed power divider ratio, and configurability may be provided one or more of the configurable impedance transformation circuit 212(1) or the configurable impedance transformation circuit 212(2). In one or more embodiments, the unequal Wilkinson power divider/combiner circuit 208 may also be programmable to include an adjustable power ratio and one or more of the configurable impedance transformation circuits 212(1) or 212(2) may attenuate the signals, introduce a selected phase shift between the signals, or both.

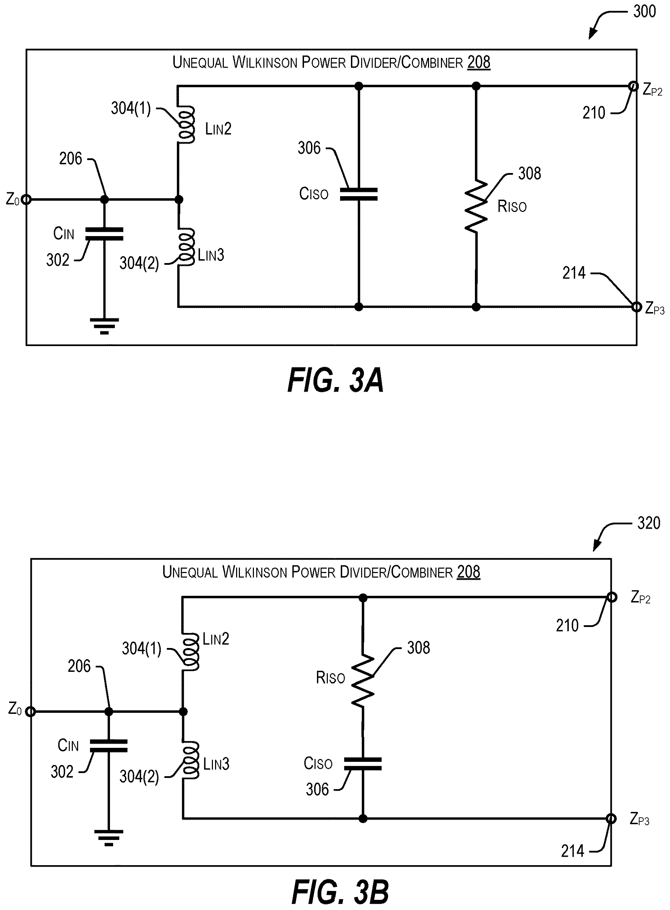

FIG. 3A depicts a low-pass unequal power divider/combiner circuit 300 with a parallel resistor-capacitor isolation network, in accordance with certain embodiments. The power divider /combiner circuit 300 may be an embodiment of the unequal Wilkinson power divider 208 in FIG. 2. The unequal Wilkinson power divider 208 may include a node 206 configured to receive an RF input signal. The circuit 300 may include a capacitor 302 including a first terminal coupled to the node 206 and a second terminal coupled to ground. The circuit 300 may include a first inductor 304(1) including a first terminal coupled to the node 206 and a second terminal coupled to the node 210. The circuit 300 may include a second inductor 304(2) including a first terminal coupled to the node 206 and a second terminal coupled to the node 214. The capacitor 302, the first inductor 304(1), and the second inductor 304(2) may serve as an impedance transformation circuit from the nodes 210 ($Z_{P2}$) and 214 ($Z_{P3}$) to node 206 ($Z_0$).

The circuit 300 may include a capacitor 306 including a first terminal coupled to the node 210 and a second terminal coupled to the node 214. The circuit 300 may include a resistor 308 including a first terminal coupled to the node 210 and a second terminal coupled to the node 214. The parallel RC network provided by the capacitor 306 and the resistor 308 may provide output isolation between the node 210 ($Z_{P2}$) and the node 214 ($Z_{P3}$).

As compared to a conventional Wilkinson power divider, which may provide signals having equal power to both nodes 210 and 214, the circuit 300 may be configured to deliver power to the node 210 that is N times higher than the power delivered to the node 214. In the illustrated embodiment, the output impedances may be determined according to the

following equations:

$$Z_{P2} = \frac{Z_0}{N}, Z_{P3} = Z_0. \tag{3}$$

where $Z_0$ represents the output impedance of the node 206, $Z_{P2}$ represents the output impedance of the node 210, $Z_{P3}$ represents the output impedance of the node 214, and $N$ represents the power-division ratio. The inductor values may be determined according to the following equations:

$$L_{IN2} = \frac{Z_0}{\omega\sqrt{N}}, L_{IN3} = \frac{Z_0\sqrt{N}}{\omega}. \tag{4}$$

where $\omega$ represents the angular frequency of the RF input signal.

The capacitance of the input capacitor 302 may be determined according to the following equation:

$$C_{IN} = \frac{\sqrt{N}}{\omega Z_0}. \tag{5}$$

The resistor-capacitor (RC) isolation network may be determined according to the following equations:

$$C_{ISO} = \frac{\sqrt{N}}{\omega Z_0 (N+1)}, \tag{6}$$

where $C_{ISO}$ represents the capacitance of the capacitor 306. The resistance $R_{ISO}$ of the resistor 308 may be determined as follows:

$$R_{ISO} = \frac{(N+1)Z_0}{N}. \tag{7}$$

The illustrative embodiment of the circuit 300 of FIG. 3A depicts an isolation network including the capacitor 306 and the resistor 308 arranged in parallel between the node 210 and the node 214. In one or more embodiments, the isolation network may be configured in series instead of parallel. An embodiment of such an isolation network is described below with respect to FIG. 3B.

FIG. 3B depicts a low-pass unequal power divider/combiner circuit 320 with a series resistor-capacitor isolation network, in accordance with certain embodiments. The power divider/combiner circuit 320 may be an embodiment of the unequal Wilkinson power divider 208 in FIG. 2. The circuit 320 has all the elements of the circuit 300 of FIG. 3A, except that the isolation network has been rearranged so that the capacitor 306 and the resistor 308 are in series between the node 210 and the node 214.

The component values for the circuit 320 are the same as for the circuit 300 except for the values for the capacitor 306 and the resistor 308 of the isolation network. The capacitance $C_{ISO}$ of the capacitor 306 may be determined according to the following equation:

$$C_{ISO} = \frac{\sqrt{N}}{\omega Z_0}. \tag{8}$$

The resistance $R_{ISO}$ may be determined according to the following equation:

$$R_{ISO} = Z_0. \tag{9}$$

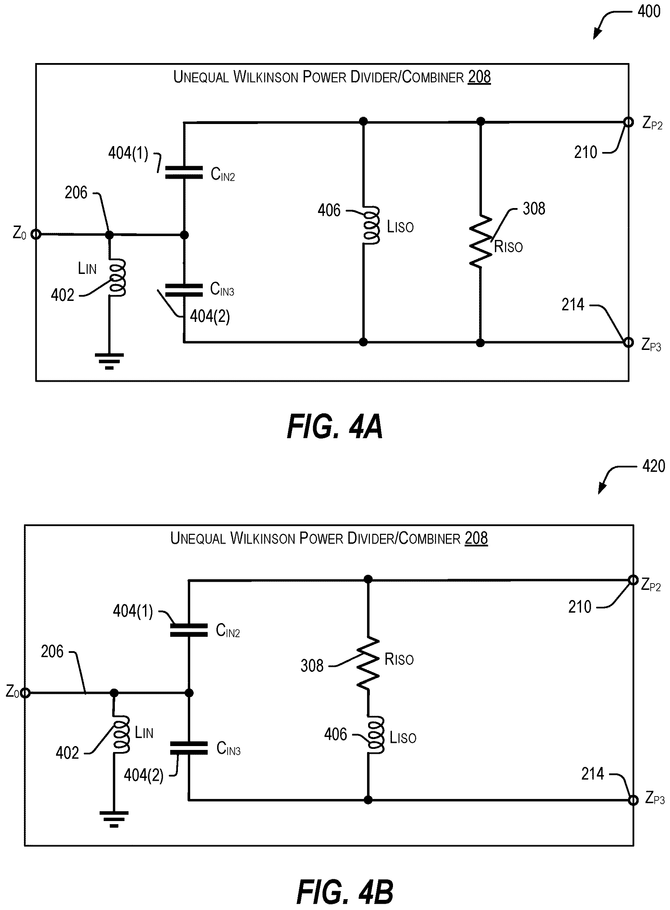

The embodiments of FIGs. 3A and 3B include inductors 304 in series between the node 206 and the nodes 210 and 214, producing a low-pass filter implementation. The power divider/combiner circuit 206 may also be implemented as a high-pass filter. Embodiments of high-pass filter implementations are described below with respect to FIGs. 4A and 4B.

FIG. 4A depicts a high-pass unequal power divider/combiner circuit 400 with a parallel resistor-inductor isolation network, in accordance with certain embodiments. The circuit 400 may be an embodiment of the circuit 208 in FIG. 2. In the illustrated embodiment, the circuit 400 may include an inductor (input inductor $L_{IN}$) 402 including a first terminal coupled to the node 206 and a second terminal coupled to ground. The circuit 400 may include a first capacitor 404(1) including a first terminal coupled to the node 206 and a second terminal coupled to the node 210. The circuit 400 may include a second capacitor 404(2) including a first terminal coupled to the node 206 and a second terminal coupled to the node 214. The circuit 400 may include an isolation network provided by an inductor 406 and a resistor 308, which may be coupled in parallel between the node 210 and the node 214. The inductor 402, the first capacitor 404(1), and the second capacitor 404(2) may also provide an impedance transformation from the nodes 210 ($Z_{P2}$) and 214 ($Z_{P3}$) to the node 206 ($Z_0$).

In the illustrated embodiment, the input impedances may be determined according to the following equations:

$$Z_{P2} = \frac{Z_0}{N}, Z_{P3} = Z_0. \tag{10}$$

where $Z_0$ represents the input impedance of the node 206, $Z_{P2}$ represents the input impedance of the node 210, $Z_{P3}$ represents the input impedance of the node 214, and $N$ represents the power-division ratio. The capacitances of capacitor ($C_{IN2}$) 404(1) and 404 may be determined according to the following equation:

$$C_{IN2} = \frac{\sqrt{N}}{\omega Z_0}, \text{ and } C_{IN3} = \frac{1}{\omega Z_0 \sqrt{N}} \tag{11}$$

The input inductor value may be determined according to the following equation:

$$L_{IN} = \frac{Z_0}{\omega\sqrt{N}}. \tag{12}$$

where $\omega$ represents the angular frequency of the RF input signal.

The inductor-capacitor (LC) isolation network may be determined according to the following equations:

$$L_{ISO} = \frac{Z_0(N+1)}{\omega\sqrt{N}}, \tag{13}$$

where $L_{ISO}$ represents the inductance of the inductor 406. The resistance $R_{ISO}$ of the resistor 308 may be determined as follows:

$$R_{ISO} = \frac{(N+1)Z_0}{N}. \tag{14}$$

The illustrative embodiment of the circuit 400 of FIG. 4A depicts an isolation network including the inductor 406 and the resistor 308 arranged in parallel between the node 210 and the node 214. In one or more embodiments, the isolation network may be configured in series instead of parallel. An embodiment of such an isolation network is described below with respect to FIG. 4B.

FIG. 4B depicts a high-pass unequal power divider/combiner circuit 420 with a series resistor-inductor isolation network, in accordance with certain embodiments. The power divider/combiner circuit 420 may be an embodiment of the unequal Wilkinson power divider 208 in FIG. 2. The circuit 420 has all the elements of the circuit 400 of FIG. 4A, except that the isolation network has been rearranged so that the inductor 406 and the resistor 308 are in series between the node 210 and the node 214.

The component values for the circuit 420 are the same as for the circuit 400 except for the values for the inductor 406 and the resistor 308 of the isolation network. The inductance $L_{ISO}$ of the inductor 406 may be determined according to the following equation:

$$L_{ISO} = \frac{Z_0}{\omega\sqrt{N}}. \tag{15}$$

The resistance $R_{ISO}$ of the resistor 308 may be determined according to the following equation:

$$R_{ISO} = Z_0. \tag{16}$$

The embodiments of FIGs. 4A and 4B include capacitors 404 in series between the node 206 and the nodes 210 and 214, producing a high-pass filter implementation.

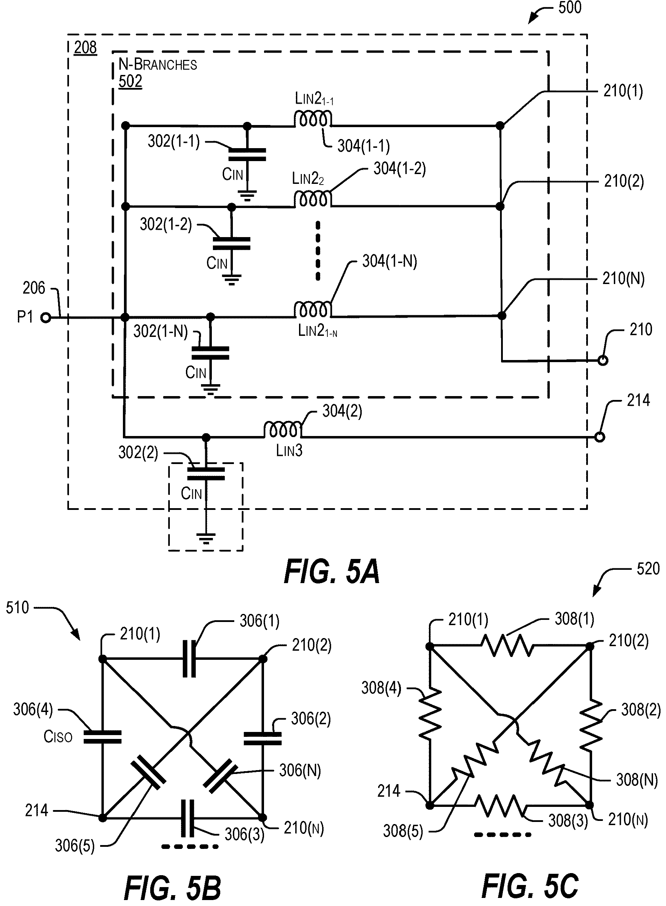

In one or more embodiments, the unequal Wilkinson power divider/combiner circuit 208 may be implemented with a fixed power divide ratio or a programmable power divide ratio. In one or more embodiments, the power divide ratio may be provided by including multiple inductive or capacitive branches in one or both of the conductive paths between the node 206 and the node 210 and between the node 206 and the node 214. An example of an embodiment of a Wilkinson power divider/combiner circuit 208 having a programmable power divide ratio is described below with respect to FIGs. 5A-5C.

FIG. 5A depicts a diagram of a low-pass unequal power divider/combiner circuit 500 including a plurality of inductor-capacitor branches, in accordance with certain embodiments. The circuit 500 may include an embodiment of the unequal Wilkinson power divider/combiner circuit 208. The circuit 500 may include input capacitors ($C_{IN}$) 302, each of which may include a first terminal coupled to the node 206 and a second terminal coupled to ground. The circuit 500 may include a capacitor 302(2) including a first terminal coupled to the node 206 and a second terminal coupled to ground. The circuit 500 may include an inductor 304(2) including a first terminal coupled to the first terminal of the capacitor 302(2) and including a second terminal coupled to the node 214. The capacitor 302(2) and the inductor $L_{IN3}$ 304(2) may provide a low-pass filter in the electrical path between the node 206 and the node 214, which may be coupled to the main or carrier amplifier 110(2) in FIGs. 1A and 1B.

The electric path between the node 206 and the node 210 may include a plurality of inductive branches (N Branches) 502. Each inductive branch 502 may include a capacitor 302(1) and an inductor 304(1). Each capacitor 302(1) may include a first terminal coupled to the node 206 and a second terminal coupled to ground, and each inductor 304(1) may include a first terminal configured to be coupled to the first terminal of the capacitor 302(1) and a second terminal coupled to a split node 210(1), 210(2), ..., or 210(N). In one or more other embodiments, the capacitors 302 and the inductors 304 may be switched to provide capacitive branches in which each capacitive branch may include an inductor 304(1) having a first terminal coupled to the node 206 and a second terminal coupled to ground and may include a capacitor 302(1) having a first terminal coupled to the first terminal of the inductor 304(1) and a second terminal coupled to a split node 210(1), 210(2), ..., or 210(N).

The split nodes 210(1), 210(2), ..., and 210(N) may be shorted to the node 210. In one or more embodiments, the unequal Wilkinson power divider/combiner circuit 208 may be implemented with a fixed power division ratio determined by the number of branches 502. In one or more alternative embodiments, each branch 502 may include a switch (not shown) between the node 206 and the first terminal of the capacitors 302(1-1) to 302(1-N), enabling a programmable power division ratio by selectively coupling one or more of the capacitor-inductor pairs between the node 206 and the node 210.

In the illustrated embodiment, the plurality of branches 502 may include a first branch including a first capacitor (CIN) 302(1-1) and a first inductor ($LIN2_{1-1}$) 304(1-1). The first capacitor 302(1-1) may include a first terminal coupled to the node 206 and a second terminal coupled to ground. The first inductor 304(1-1) may include a first terminal coupled to the first terminal of the capacitor 302(1-1) and a second terminal coupled to a first split node 210(1).

The plurality of branches 502 may include a second branch including a second capacitor (CIN) 302(1-2) and a second inductor ($LIN2_{1-2}$) 304(1-2). The second capacitor 302(1-2) may include a first terminal coupled to the node 206 and a second terminal coupled to ground. The second inductor 304(1-2) may include a first terminal coupled to the first terminal of the capacitor 302(1-2) and a second terminal coupled to a second split node 210(2).

The plurality of branches 502 may include a number $N$ of branches to provide a power divide ratio (N:1). The N-th branch may include an N-th capacitor 302(1-N) and an N-th inductor ($LIN2_{1-N}$) 304(1-N). The N-th capacitor 302(1-N) may include a first terminal coupled to the node 206 and a second terminal coupled to ground. The N-th inductor 304(1-N) may include a first terminal coupled to the first terminal of the capacitor 302(1-N) and a second terminal coupled to an N-th split node 210(N).

In the illustrated embodiment, the split nodes 210(1), 210(2), ..., and 210(N) may have the same impedance as the node 210 in FIGs. 3A-4B, i.e., $Z_0$. The N-branches 502 may transform the impedance $Z_0$ to be approximately $Z_0*(N+1)$. The values of the inductors 304 may be determined according to the following equation:

$$L_{IN} = \frac{Z_0\sqrt{N}}{\omega} \tag{17}$$

The input capacitance may be determined according to the following equation.

$$C_{IN} = \frac{\sqrt{N}}{\omega Z_0 (N+1)} \tag{18}$$

In the embodiment of FIG. 5A, an isolation network may be provided between each of the nodes 210 and the node 214. In one or more embodiments, each isolation network may include a resistor and a capacitor coupled between each of the split nodes 210 and between one or more of the split nodes 210 and the node 214. Since the interconnections of the resistive and capacitive isolation networks would unduly complicate the drawing of FIG. 5A, the isolation networks are depicted in FIGs. 5B and 5C.

FIG. 5B depicts a diagram of a capacitive isolation network 510, in accordance with certain embodiments. The capacitive isolation network 510 may include one or more isolation capacitors 306 coupled between one of the split nodes 210 and others of the split nodes 210 or the node 214. The capacitive isolation network 510 may include a first capacitor 306(1) including a first terminal coupled to the node 210(1) and a second terminal coupled to the node 210(2). The capacitive isolation network 510 may include a second capacitor 306(2) including a first terminal coupled to the node 210(2) and a second terminal coupled to the node 210(N). The capacitive isolation network 510 may include a third capacitor 306(3) including a first terminal coupled to the node 210(N) and a second terminal coupled to the node 214. The capacitive isolation network 510 may include a fourth capacitor 306(4) including a first terminal coupled to the node 210(1) and a second terminal coupled to the node 214.

The capacitive isolation network 510 may include a fifth capacitor 306(5) including a first terminal coupled to the node 210(2) and a second terminal coupled to the node 214. The capacitive isolation network 510 may include an N-th capacitor 306(N) including a first terminal coupled to the node 210(1) and a second terminal coupled to the node 210(N). It should be understood that the capacitive isolation network 510 may include any number of capacitors.

FIG. 5C depicts a diagram of a resistive isolation network 520, in accordance with certain embodiments. The resistive isolation network 520 may include one or more isolation resistors 308 coupled between one of the split nodes 210 and others of the split nodes 210 or the node 214. The resistive isolation network 520 may include a first resistor 308(1) including a first terminal coupled to the node 210(1) and a second terminal coupled to the node 210(2). The resistive isolation network 520 may include a second resistor 308(2) including a first terminal coupled to the node 210(2) and a second terminal coupled to the node 210(N). The resistive isolation network 520 may include a third resistor 308(3) including a first terminal coupled to the node 210(N) and a second terminal coupled to the node 214. The resistive isolation network 520 may include a fourth resistor 308(4) including a first terminal coupled to the node 210(1) and a second terminal coupled to the node 214.

The resistive isolation network 520 may include a fifth resistor 308(5) including a first terminal coupled to the node 210(2) and a second terminal coupled to the node 214. The resistive isolation network 510 may include an N-th resistor 308(N) including a first terminal coupled to the node 210(1) and a second terminal coupled to the node 210(N). It should be understood that the resistive isolation network 520 may include any number of resistors.

The split nodes 210(1), 210(2), ..., and 210(N) may be shorted to a single node 210, which may produce the topology and values depicted with respect to FIG. 3A. In one or more embodiments, the capacitive isolation network 510 and the resistive isolation network 520 may be combined such that the resistors 308 and the capacitors 306 are arranged in series between the nodes and, when the split nodes 210(1), 210(2), ..., and 210(N) are shorted to a single node 210, the topology and values depicted with respect to FIG. 3B may be realized. Thus, for the unequal Wilkinson power divider/combiner circuit 208 in FIG. 3A, the impedance ($Z_{P2}$) and the series inductance ($L_{IN2}$) of the electrical path between the node 206 and the node 210 may be N times lower than the impedance ($Z_{P3}$) and the series inductance ($L_{IN3}$) of the electrical path between the node 206 and the node 214.

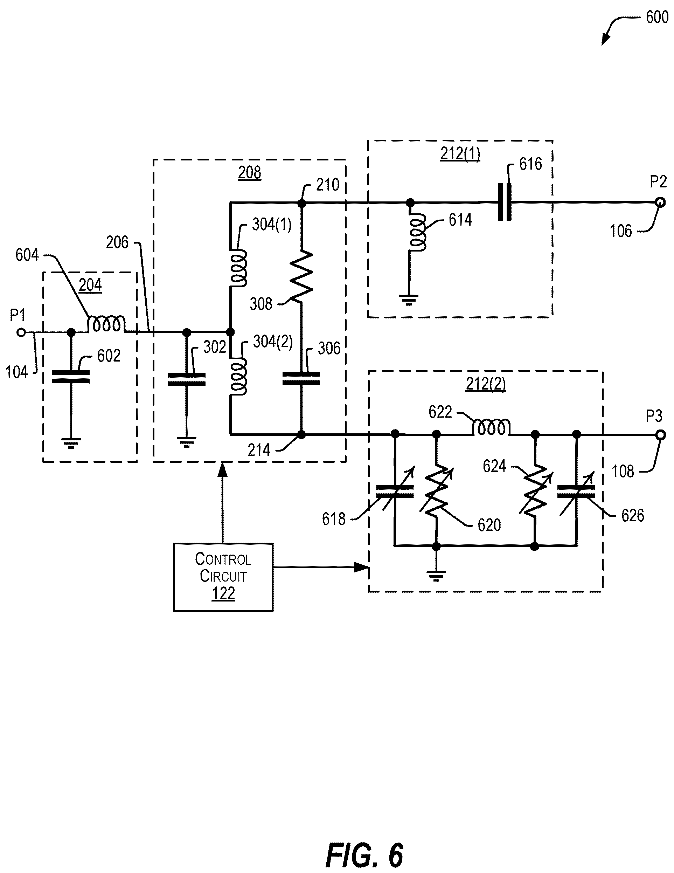

FIG. 6 depicts a diagram of an embodiment of a circuit 600 including an embodiment of the configurable unequal power divider/combiner circuit 208 of FIG. 2 including configurable impedance transformation circuits to provide a positive phase difference between output ports (P2 and P3) 106 and 108 that is suitable for the inverted Doherty power amplifier of FIG. 1B. The unequal Wilkinson power divider/combiner circuit 208 may be implemented using any of the embodiments depicted in FIGs. 3A-4B. In this example, the circuit 600 may include the impedance matching network 204 including a capacitor 602 and an inductor 604. The capacitor 602 may include a first terminal coupled to the node (P1) 104 and a second terminal coupled to ground. The inductor 604 may include a first terminal coupled to the node (P1) 104 and a second terminal coupled to the node 206. As previously indicated, in one or more embodiments, the impedance matching network 204 may be omitted.

The circuit 600 may include an unequal Wilkinson power divider/combiner circuit 208 including capacitors 302 and 306, inductors 304(1) and 304(2), and the resistor 308 as in FIG. 3B. The capacitor 302 may include a first terminal coupled to the node 206 and a second terminal coupled to ground. The inductor 304(1) may include a first terminal coupled to the node 206 and a second terminal coupled to the node 210. The inductor 304(2) may include a first terminal coupled to the node 206 and a second terminal coupled to the node 214. The resistor 308 and the capacitor 306 may be arranged in series between the nodes 210 and 214 to provide an isolation network.

The circuit 600 may include the first configurable impedance transformation circuit 212(1) and the second configurable impedance transformation circuit 212(2). The first configurable impedance transformation circuit 212(1) may include an inductor 614 including a first terminal coupled to the node 210 and a second terminal coupled to ground. The first configurable impedance transformation circuit 212(1) may include a capacitor 616 including a first terminal coupled to the node 210 and a second terminal coupled to the port (P2) 106, providing a high-pass filter. In one or more embodiments, the first configurable impedance transformation circuit 212(1) may be omitted.

The second configurable impedance transformation circuit 212(2) may include an inductor 622, a first tunable capacitor 618, a first tunable resistor 620, a second tunable resistor 624, and a second tunable capacitor 626. The inductor 622 may include a first terminal coupled to the node 214 and a second terminal coupled to the port (P3) 108 to provide a low-pass filter. The first tunable capacitor 618 may include a first terminal coupled to the node 214 and a second terminal coupled to ground. The first tunable resistor 620 may include a first terminal coupled to the node 214 and a second terminal coupled to ground. The second tunable resistor 624 may include a first terminal coupled to the port 108 and a second terminal coupled to ground. The second tunable capacitor 626 may include a first terminal coupled to the port 108 and a second terminal coupled to ground. In this example, the tunable resistors 620 and 624 and the tunable capacitors 618 and 626 may be responsive to one or more control signals from a control circuit 122 to adjust the resistances and the capacitances to provide a selected impedance transformation network. In the illustrated example, in one or more embodiments, the first configurable impedance transformation circuit 212(1) may introduce a negative 45-degree phase shift, and the second configurable transformation circuit 212(2) may introduce a positive 45-degree phase shift.

In one or more embodiments, one or more tunable capacitors and one or more tunable resistors may be provided in the first configurable impedance transformation circuit 212(1). In one or more embodiments, the tunable resistors 620 and 624 and the tunable capacitors 618 and 626 may have a limited quality factor (Q-factor) and may introduce extra insertion loss. The circuit 600 may utilize the natural insertion loss (IL) of the tunable resistors 620 and 624 and the tunable capacitors 618 and 626 to decrease the power at the port (P3) 108 and to create or adjust the power division ratio between the ports 106 and 108.

In the illustrated embodiment, the first configurable impedance transformation circuit 212(1) is depicted as including fixed circuit components. In one or more embodiments, the first configurable impedance transformation circuit 212(1) may include one or more tunable resistors and one or more tunable capacitors.

In the illustrated embodiment, the resistors 620 and 624 are coupled to the node 214 and the port 108, respectively, on either side of the series inductor 622. Similarly, the capacitors 618 and 626 are coupled to the node 214 and the port 108, respectively, on either side of the series inductor 622. By positioning the tunable resistors 620 and 624 and the tunable capacitors 618 and 626 on both sides of the series inductor 622, an acceptable return loss can be maintained during the reconfiguration (with different resistance and capacitance values). The tunable resistors 620 and 624 and the tunable capacitors 618 and 626 are coupled in parallel, which is less sensitive to substrate loss than if the tunable components were coupled in series between the node 214 and the port 108. This topology enables the configurable impedance circuits 212 without requiring high quality switch devices. In one or more embodiments, a silicon-germanium (SiGe) power amplifier (PA) driver with the dynamic unequal power divider 208 and the configurable impedance transformation circuits 212 may be implemented on the same die.

In one or more embodiments, the unequal Wilkinson power divider/combiner circuit 208, the configurable impedance transformation circuit 212(2), and optionally the configurable impedance transformation circuit 212(1) may be configured to receive one or more control signals from the control circuit 122 to provide a configurable power division ratio between the port 106 and the port 108. In one or more embodiments, the configurable impedance transformation circuit 212(2) may be configured to adjust the power division ratio over a range of 2dB to 4dB, for example. In one or more other embodiments, the configurable impedance transformation circuit 212(2) may be configured to adjust the power division ratio over a selected range, which may be greater than two decibels.

In one or more embodiments, the unequal Wilkinson power divider/combiner circuit 208 may be programmable to provide a selected power division between the nodes 210 and 214. In an example, the circuit 208 may include a switched capacitor network or a switchable inductor network responsive to control signals from the control circuit 122 to provide a selected power division ratio. In one or more embodiments, the configurable impedance transformation circuit 212(2) may be configured in conjunction with one or more of the configurable impedance transformation circuit 212(1) or the configurable unequal Wilkinson power divider/combiner circuit 208 to provide a larger power division ratio or to provide greater resolution across the range of values.

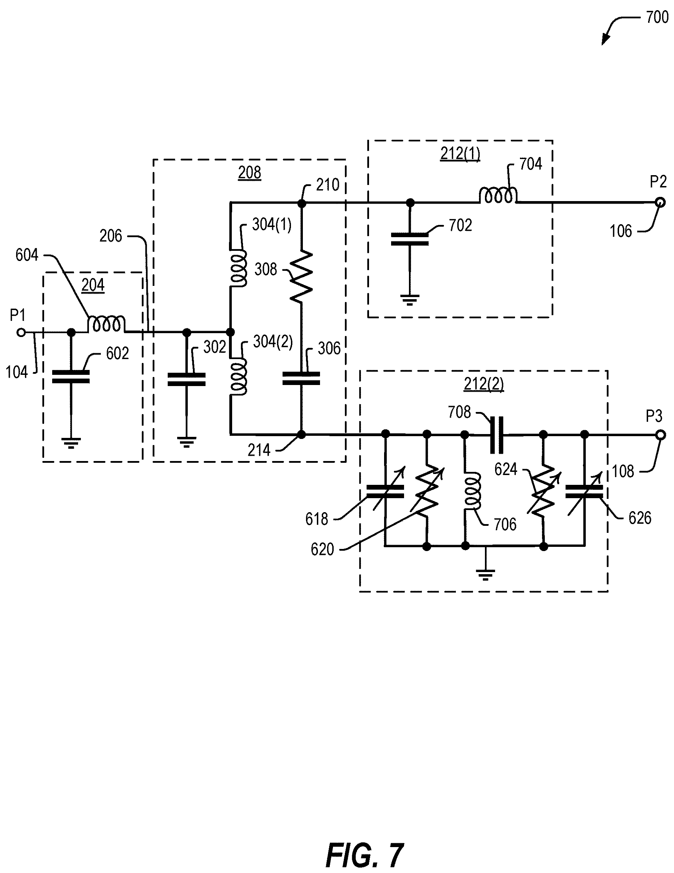

FIG. 7 depicts a diagram of an embodiment of a circuit 700 including the configurable unequal power divider/combiner circuit 208 of FIG. 2 and including configurable impedance transformation circuits 212 to provide a negative phase difference between output ports 106 and 108 that is suitable for the Doherty power amplifier of FIG. 1A. The circuit 700 may include an impedance matching circuit 204 and an unequal Wilkinson power divider/combiner circuit 208 as in FIG. 6. In one or more embodiments, the impedance matching circuit 204 may be omitted. The unequal Wilkinson power divider/combiner circuit 208 may be implemented using any of the embodiments depicted in FIGs. 3A-4B.

Unlike the circuit 600 in FIG. 6, in the illustrated embodiment of FIG. 7, the circuit 700 includes a first configurable impedance transformation circuit 212(1) implemented as a low-pass filter and a second configurable impedance transformation circuit 212(2) implemented as a high-pass filter. In the illustrated example, in one or more embodiments, the first configurable impedance transformation circuit 212(1) may introduce a positive 45-degree phase shift, and the second configurable transformation circuit 212(2) may introduce a negative 45-degree phase shift. The first configurable impedance transformation circuit 212(1) may include a capacitor 702 including a first terminal coupled to the node 210 and a second terminal coupled to ground. The first configurable impedance transformation circuit 212(1) may include an inductor 704 including a first terminal coupled to the node 210 and a second terminal coupled to the port (P2) 106.

The second configurable impedance transformation circuit 212(2) may include a capacitor 708 including a first terminal coupled to the node 214 and a second terminal coupled to the port (P3) 108 to provide a high-pass filter. Thus, the phase difference between the signals at the ports 106 and 108 is negative, which is suitable for the conventional Doherty power amplifier in FIG. 1A. The tunable capacitor 618 and the tunable resistor 620 may be coupled between the node 214 and ground. The tunable capacitor 626 and the tunable resistor 624 may be coupled between the port (P3) 108 and ground. The second configurable impedance transformation circuit 212(2) may include an inductor 706 including a first terminal coupled to the node 214 and a second terminal coupled to ground.

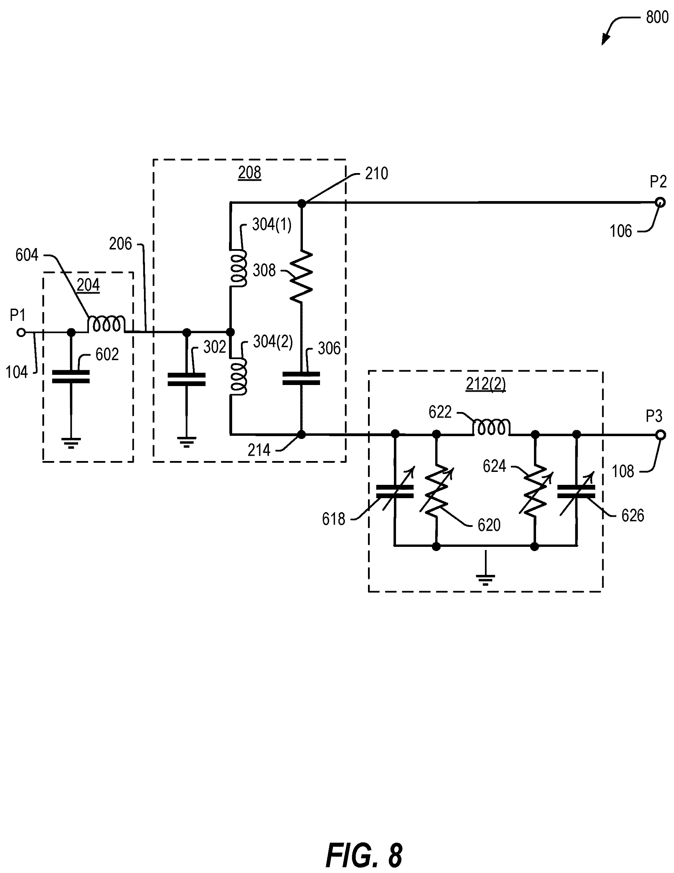

FIG. 8 depicts a diagram of an embodiment of a circuit 800 including the configurable unequal power divider/combiner circuit 208 of FIG. 2 and including a configurable impedance transformation circuit 212(2) in one of the output paths to provide a positive phase difference between output ports (P2 and P3) 106 and 108 that is suitable for the inverted Doherty power amplifier of FIG. 1B. The circuit 800 may include all the elements of the circuit 600 of FIG. 6 except that the first configurable impedance transformation circuit 212(1) is omitted, and the node 210 is directly connected to the port (P2) 106.

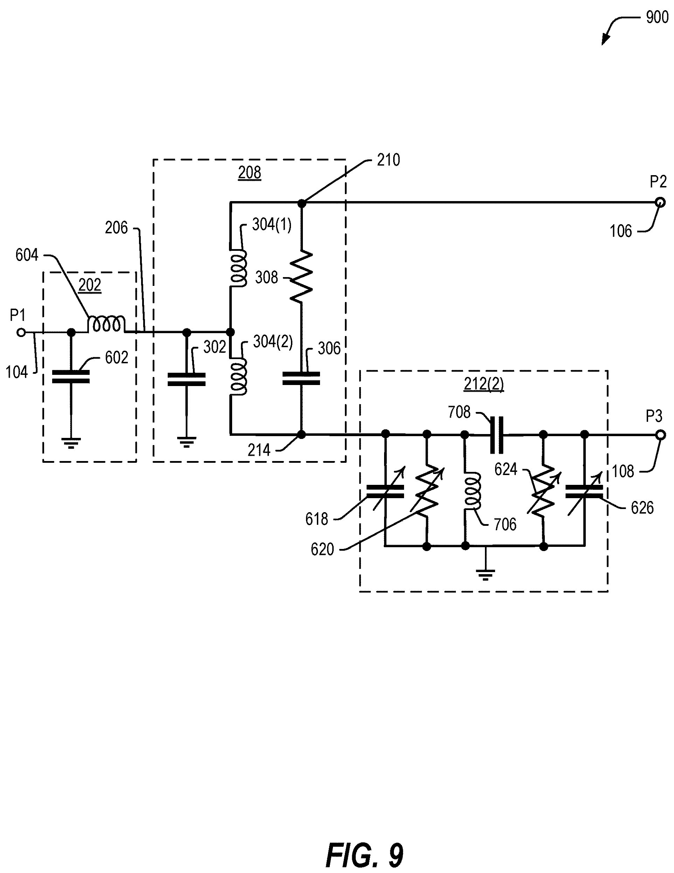

FIG. 9 depicts a diagram of an embodiment of a circuit 900 including the configurable unequal power divider/combiner circuit 208 of FIG. 2 and including a configurable impedance transformation circuit 212(2) in one of the output paths to provide a negative phase difference between output ports (P2 and P3) 106 and 108 that is suitable for the Doherty power amplifier of FIG. 1A. The circuit 900 may include all the elements of the circuit 700 of FIG. 7 except that the first configurable impedance transformation circuit 212(1) is omitted, and the node 210 is directly connected to the port (P2) 106.

In one or more embodiments, as shown in FIGs. 8 and 9, the first configurable impedance transformation circuit 212(1) may be omitted, because the second configurable impedance transformation circuit 212(2) can transform the impedance for the low-power branch of the unequal Wilkinson power divider 208. In one or more embodiments, the second configurable impedance transformation circuit 212(2) may be configured to provide a ninety-degree (90°) phase shift. By omitting the first configurable impedance transformation circuit 212(1), insertion losses are confined to the second configurable impedance transformation circuit 212(2), which makes use of the insertion loss to achieve the power division ratio between the ports 106 and 108. In one or more embodiments, by using the second configurable impedance transformation circuit 212(2) (low power branch) to provide the attenuation, the overall insertion loss $IL$ may be optimized.

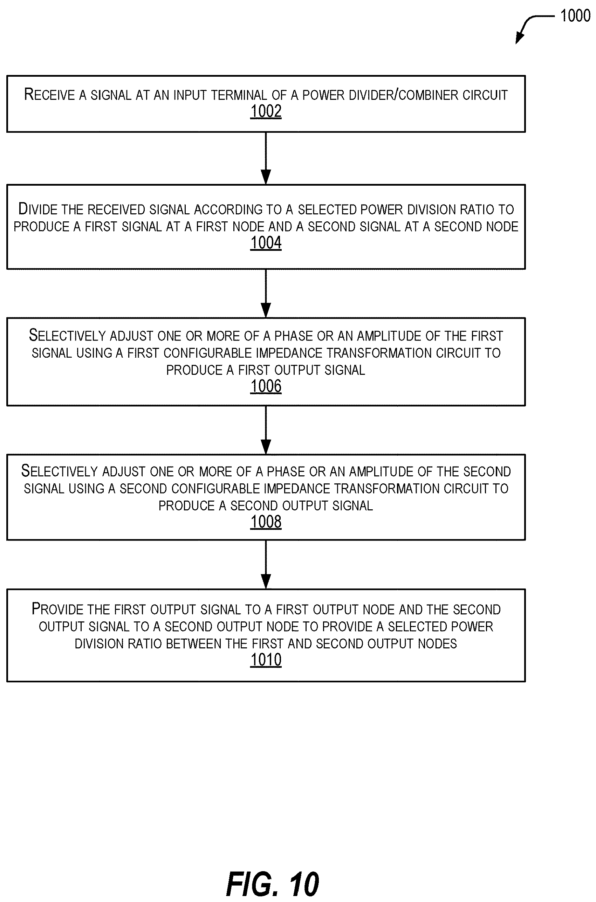

FIG. 10 depicts a flow diagram of a method 1000 of dividing power of an input signal to produce output signals having a selected power ratio and a selected phase difference, in accordance with certain embodiments. In one or more embodiments, the method 1000 may be implemented by any of the circuits described above with respect to FIGs. 2-9.

At 1002, the method 1000 may include receiving a signal at an input terminal of a power divider/combiner circuit. In one or more embodiments, the signal may be a radio frequency (RF) signal having an oscillation rate (of an alternating electric current or voltage or of a magnetic, electric, or electromagnetic field in the frequency range from about twenty kilohertz (20 kHz) to three hundred gigahertz (300 GHz) or higher. In one or more embodiments, the RF signal may be received at the port (P1) 104 of a circuit that includes the programmable unequal power divider/combiner circuit 102 of FIG. 2, which may include the impedance matching circuit 204 and which includes the unequal Wilkinson power divider/combiner circuit 208 and one or more configurable impedance circuits 212.

At 1004, the method 1000 may include dividing the received signal according to a selected power division ratio to produce a first signal at a first node and a second signal at a second node. In one or more embodiments, the first signal and the second signal may be produced by an unequal Wilkinson power divider/combiner circuit 208 according to any of the embodiments depicted in FIGs. 2-9. The first signal may be provided to the node 210 and the second signal may be provided to the node 214.

At 1006, the method 1000 may include selectively adjusting one or more of a phase or an amplitude of the first signal using a first configurable impedance transformation circuit 212(1) to produce a first output signal. In one or more embodiments, the first configurable impedance transformation circuit 212(1) may be omitted, and the node 210 may be connected to the output port (P2) 106.

At 1008, the method 1000 may include selectively adjusting one or more of a phase or an amplitude of the second signal using a second configurable impedance transformation circuit 212(2) to produce a second output signal. The first and second configurable impedance transformation circuits 212(1) and 212(2) may be responsive to one or more control signals from a control circuit 122 to configure one or more of the attenuation adjustment or the phase adjustment.

At 1010, the method 1000 may include providing the first output signal to the first output node and the second output signal to a second output node to provide a selected power division ratio between the first and second output nodes. In one or more embodiments, the first output signal may be provided to the port (P2) 106, and the second output signal may be provided to the port (P3) 108. A power division ratio between the first output signal and the second output signal may be determined by a combination of the power division provided by the unequal Wilkinson power divider/combiner circuit 208 and one or more of the first configurable impedance transformation circuit 212(1) or the second configurable impedance transformation circuit 212(2).

Embodiments disclosed herein may be further understood in view of the following examples.

Example 1: A power divider/combiner circuit 102 may include a first port 104 configured to receive a signal; a second port 106; a third port 108; an unequal Wilkinson power divider/combiner circuit 208 including a first node 206 coupled to the first port 104 , a second node 210 coupled to the second port 106, and a third node 214, the programmable unequal power divider/combiner circuit 102 configured to receive the signal at the port 104 and to divide the signal to produce a first signal at the second node 210 and a second signal at the third node 214; and a configurable impedance transformation circuit 212(2) coupled between the third node 214 and the third port 108, the configurable impedance transformation circuit 212(2) configured to provide a configurable phase shift and a configurable attenuation of the second signal to provide a selected power division ratio between the first signal at the second port 106 and the second signal at the third port 108.

Example 2: The power divider/combiner circuit 102 of Example 1, where the configurable impedance transformation circuit 212(2) may include an inductor 622 including a first terminal coupled to the third node 214 and a second terminal coupled to the third port 108; a first tunable resistor 620 including a first terminal coupled to the third node 214 and a second terminal coupled to ground; a first tunable capacitor 618 including a first terminal coupled to the third node 214 and a second terminal coupled to ground; a second tunable resistor 624 including a first terminal coupled to the third port 108 and a second terminal coupled to ground; and a second tunable capacitor 626 including a first terminal coupled to the third port 108 and a second terminal coupled to ground; and where one or more of the first tunable resistor 620, the second tunable resistor 624, the first tunable capacitor 618, or the second tunable capacitor 626 is responsive to one or more control signals from a control circuit 122 to adjust one or more of a phase or an attenuation of the second signal.

Example 3: The power divider/combiner circuit 102 of Example 1, where the configurable impedance transformation circuit 212(2) may include a capacitor 708 including a first terminal coupled to the third node 214 and a second terminal coupled to the third port 108; a first tunable resistor 620 including a first terminal coupled to the third node 214 and a second terminal coupled to ground; a first tunable capacitor 618 including a first terminal coupled to the third node 214 and a second terminal coupled to ground; an inductor 706 including a first terminal coupled to the third node 214 and a second terminal coupled to ground; a second tunable resistor 624 including a first terminal coupled to the third port 108 and a second terminal coupled to ground; and a second tunable capacitor 626 including a first terminal coupled to the third port 108 and a second terminal coupled to ground; and where one or more of the first tunable resistor 620, the second tunable resistor 624, the first tunable capacitor 618, or the second tunable capacitor 626 is responsive to one or more control signals from a control circuit 122 to adjust one or more of a phase or an attenuation of the second signal.

Example 4: The power divider/combiner circuit 102 of any of the Examples 1-3, further including a second configurable impedance transformation circuit 212(1) coupled between the second node 210 and the second port 106, the second configurable impedance circuit 212(1) configured to provide a second configurable phase shift and a second configurable attenuation of the first signal.

Example 5: The power divider/combiner circuit 102 of Example 4, where the configurable impedance transformation circuit 212(2) and the second configurable impedance transformation circuit 212(1) are responsive to one or more control signals from a control circuit 122 to selectively adjust one or more of a configurable phase shift, a second configurable phase shift, a configurable attenuation or a second configurable attenuation to provide the selected power division ratio between the first signal at the second port 106 and the second signal at the third port 108.

Example 6: The power divider/combiner circuit 102 of any of the Examples 1-5, where the unequal Wilkinson power divider/combiner circuit 208 may include an input capacitor 302 including a first terminal coupled to the first node 206 and a second terminal coupled to ground; at least one first inductor 304(1) including a first terminal coupled to the first node 206 and a second terminal coupled to the second node 210; a second inductor 304(2) including a first terminal coupled to the first node 206 and a second terminal coupled to the third node 214; and an isolation network (capacitor 306 and resistor 308) coupled between the second node 210 and the third node 214.

Example 7: The power divider/combiner circuit 102 of Example 6, where the at least one first inductor 304(1) comprises a plurality of inductors 304(1-1), 304(1-2), ..., 304(1-N) in parallel between the first node 206 and the second node 210.

Example 8: The power divider/combiner circuit 102 of Example 6, where the isolation network comprises a resistor 308 and a capacitor 306 in series between the second node 210 and the third node 214.

Example 9: The power divider/combiner circuit of Example 6, where the isolation network comprises a resistor 308 and a capacitor 310 in parallel between the second node 210 and the third node 214.

Example 10: The power divider/combiner circuit 102 of any of Examples 1-9, where the unequal Wilkinson power divider/combiner circuit 208 may include an input inductor 402 including a first terminal coupled to the first node 206 and a second terminal coupled to ground; at least one first capacitor 404(1) including a first terminal coupled to the first node 206 and a second terminal coupled to the second node 210; a second capacitor 404(2) including a first terminal coupled to the first node 206 and a second terminal coupled to the third node 214; and an isolation network coupled between the second node and the third node.

Example 11: The power divider/combiner circuit 102 of Example 10, where the at least one first capacitor 404(1) comprises a plurality of capacitors in parallel between the first node 206 and the second node 210.

Example 12: The power divider/combiner circuit 102 of Example 10, where the isolation network comprises a resistor 308 and an inductor 306 in series between the second node 210 and the third node 214.

Example 13: The power divider/combiner circuit 102 of Example 10, where the isolation network comprises a resistor 308 and an inductor 306 in parallel between the second node 210 and the third node 214.

Example 14: A method may include receiving a radio frequency (RF) signal at a first node of a power divider/combiner circuit, the first node coupled to a first port; dividing, using an unequal Wilkinson power divider/combiner circuit, the RF signal into a first signal at a second node and a second signal at a third node; selectively adjusting, using a configurable impedance transformation circuit, one or more of a phase shift or an attenuation of the second signal; and providing the first signal to a second port and the second signal to a third port; where the first signal and the second signal define a selected power division ratio between the second port and the third port.

Example 15: The method of Example 14, further including selectively adjusting, using a second configurable impedance transformation circuit, one or more of a phase shift or an attenuation of the first signal.

Example 16: The method of Example 14, wherein selectively adjusting, using the configurable impedance transformation circuit may include providing an inductor including a first terminal coupled to the third node and a second terminal coupled to the third port; selectively adjusting a first resistance of a first tunable resistor including a first terminal coupled to the third node and a second terminal coupled to ground; selectively adjusting a first capacitance of a first tunable capacitor including a first terminal coupled to the third node and a second terminal coupled to ground; selectively adjusting a second resistance of a second tunable resistor including a first terminal coupled to the third port and a second terminal coupled to ground; and selectively adjusting a second capacitance of a second tunable capacitor including a first terminal coupled to the third port and a second terminal coupled to ground; and where one or more of the first tunable resistor, the second tunable resistor, the first tunable capacitor, or the second tunable capacitor are selectively adjusted in response to receiving one or more control signals from a control circuit to adjust one or more of a phase or an attenuation of the second signal.

Example 17: The method of Example 14, where selectively adjusting, using the configurable impedance transformation circuit may include providing a capacitor including a first terminal coupled to the third node and a second terminal coupled to the third port; providing an inductor including a first terminal coupled to the third node and a second terminal coupled to ground; selectively adjusting a first resistance of a first tunable resistor including a first terminal coupled to the third node and a second terminal coupled to ground; selectively adjusting a first capacitance of a first tunable capacitor including a first terminal coupled to the third node and a second terminal coupled to ground; selectively adjusting a second resistance of a second tunable resistor including a first terminal coupled to the third port and a second terminal coupled to ground; and selectively adjusting a second capacitance of a second tunable capacitor including a first terminal coupled to the third port and a second terminal coupled to ground; and where one or more of the first tunable resistor, the second tunable resistor, the first tunable capacitor, or the second tunable capacitor are selectively adjusted in response to receiving one or more control signals from a control circuit to adjust one or more of a phase or an attenuation of the second signal.

Example 18: The method of any of Examples 14-17, further including selectively adjusting, using a second configurable impedance transformation circuit, one or more of a second phase shift or a second attenuation of the first signal.

Example 19: The method of Example 18, further including receiving one or more control signals from a control circuit to selectively adjust one or more of the phase shift of the configurable impedance transformation circuit, the attenuation of the configurable impedance transformation circuit, the second phase shift of the second configurable impedance transformation circuit, or the second attenuation of the second configurable impedance transformation circuit to provide the selected power division ratio between the first signal at the second port and the second signal at the third port.

Example 20: The method of any of Examples 14-19, where dividing, using the unequal Wilkinson power divider/combiner circuit may include providing an input inductor including a first terminal coupled to the first node and a second terminal coupled to one of a voltage source or ground; selectively controlling one of an inductor network or a capacitor network including a first terminal coupled to the first node and a second terminal coupled to the second node to provide one of a selected inductance or a selected capacitance between the first node and the second terminal; providing one of an inductor of a capacitor including a first terminal coupled to the first node and a second terminal coupled to the third node to provide one of a second inductance or a second capacitance between the first node and the third node; and providing an isolation network coupled between the second node and the third node; and where a difference between the selected inductance and the second inductance or between the selected capacitance and the second capacitance defines an unequal power division ratio between the first signal at the second node and the second signal at the third node.

The preceding detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

The foregoing description refers to elements or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims.

**Claims**

1. A power divider/combiner circuit comprises:

   a first port configured to receive a signal;
   a second port;
   a third port;
   an unequal Wilkinson power divider/combiner circuit including a first node coupled to the first port, a second node coupled to the second port, and a third node, the unequal Wilkinson power divider/combiner circuit configured to receive the signal at the first node and to divide the signal to produce a first signal at the second node and a second signal at the third node; and
   a configurable impedance transformation circuit coupled between the third node and the third port, the configurable impedance transformation circuit configured to provide a configurable phase shift and a configurable attenuation of the second signal to provide a selected power division ratio between the first signal at the second port and the second signal at the third port.

2. The power divider/combiner circuit of claim 1, wherein the configurable impedance transformation circuit comprises:

   an inductor including a first terminal coupled to the third node and a second terminal coupled to the third port;
   a first tunable resistor including a first terminal coupled to the third node and a second terminal coupled to ground;
   a first tunable capacitor including a first terminal coupled to the third node and a second terminal coupled to ground;
   a second tunable resistor including a first terminal coupled to the third port and a second terminal coupled to ground; and
   a second tunable capacitor including a first terminal coupled to the third port and a second terminal coupled to ground; and
   wherein one or more of the first tunable resistor, the second tunable resistor, the first tunable capacitor, or the second tunable capacitor is responsive to one or more control signals from a control circuit to adjust one or more of a phase or an attenuation of the second signal.

3. The power divider/combiner circuit of claim 1, wherein the configurable impedance circuit transformation comprises:

   a capacitor including a first terminal coupled to the third node and a second terminal coupled to the third port;
   a first tunable resistor including a first terminal coupled to the third node and a second terminal coupled to ground;
   a first tunable capacitor including a first terminal coupled to the third node and a second terminal coupled to ground;
   an inductor including a first terminal coupled to the third node and a second terminal coupled to ground;

a second tunable resistor including a first terminal coupled to the third port and a second terminal coupled to ground; and

a second tunable capacitor including a first terminal coupled to the third port and a second terminal coupled to ground; and

wherein one or more of the first tunable resistor, the second tunable resistor, the first tunable capacitor, or the second tunable capacitor is responsive to one or more control signals from a control circuit to adjust one or more of a phase or an attenuation of the second signal.

4. The power divider/combiner circuit of any of claims 1 to 3, further comprising a second configurable impedance transformation circuit coupled between the second node and the second port, the second configurable impedance circuit configured to provide a second configurable phase shift and a second configurable attenuation of the first signal.

5. The power divider/combiner circuit of claim 4, wherein the configurable impedance transformation circuit and the second configurable impedance transformation circuit are responsive to one or more control signals from a control circuit to selectively adjust one or more of the configurable phase shift, the second configurable phase shift, the configurable attenuation or the second configurable attenuation to provide the selected power division ratio between the first signal at the second port and the second signal at the third port.

6. The power divider/combiner circuit of any preceding claim, wherein the unequal Wilkinson power divider/combiner circuit comprises:

a capacitor including a first terminal coupled to the first node and a second terminal coupled to ground;

at least one first inductor including a first terminal coupled to the first node and a second terminal coupled to the second node;

a second inductor including a first terminal coupled to the first node and a second terminal coupled to the third node; and

an isolation network coupled between the second node and the third node.

7. The power divider/combiner circuit of claim 6, wherein the at least one first inductor comprises a plurality of inductors in parallel between the first node and the second node.

8. The power divider/combiner circuit of claim 6 or 7, wherein the isolation network comprises a resistor and a capacitor in series between the second node and the third node.

9. The power divider/combiner circuit of claim 6 or 7, wherein the isolation network comprises a resistor and a capacitor in parallel between the second node and the third node.

10. The power divider/combiner circuit of any of claims 1 to 5, wherein the unequal Wilkinson power divider/combiner circuit comprises:

an inductor including a first terminal coupled to the first node and a second terminal coupled to ground;

at least one first capacitor including a first terminal coupled to the first node and a second terminal coupled to the second node;

a second capacitor including a first terminal coupled to the first node and a second terminal coupled to the third node; and

an isolation network coupled between the second node and the third node.

11. The power divider/combiner circuit of claim 10, wherein the at least one first capacitor comprises a plurality of capacitors in parallel between the first node and the second node.

12. A method comprising:

receiving a radio frequency, RF, signal at a first node of a power divider/combiner circuit, the first node coupled to a first port;

dividing, using an unequal Wilkinson power divider/combiner circuit, the RF signal into a first signal at a second node and a second signal at a third node;

selectively adjusting, using a configurable impedance transformation circuit, one or more of a phase shift or an attenuation of the second signal; and

providing the first signal to a second port and the second signal to a third port; and

wherein the first signal and the second signal define a selected power division ratio between the second port and the third port.

13. The method of claim 12, further comprising selectively adjusting, using a second configurable impedance transformation circuit, one or more of a phase shift or an attenuation of the first signal.

14. The method of claim 12 or 13, wherein selectively adjusting, using the configurable impedance transformation circuit comprises:

providing an inductor including a first terminal coupled to the third node and a second terminal coupled to the third port;

selectively adjusting a first resistance of a first tunable resistor including a first terminal coupled to the third node and a second terminal coupled to ground;

selectively adjusting a first capacitance of a first tunable capacitor including a first terminal coupled to the third node and a second terminal coupled to ground;

selectively adjusting a second resistance of a second tunable resistor including a first terminal coupled to the third port and a second terminal coupled to ground; and

selectively adjusting a second capacitance of a second tunable capacitor including a first terminal coupled to the third port and a second terminal coupled to ground; and

wherein one or more of the first tunable resistor, the second tunable resistor, the first tunable capacitor, or the second tunable capacitor are selectively adjusted in response to receiving one or more control signals from a control circuit to adjust one or more of a phase or an attenuation of the second signal.

15. The method of claim 12 or 13, wherein selectively adjusting, using the configurable impedance transformation circuit comprises:

providing a capacitor including a first terminal coupled to the third node and a second terminal coupled to the third port;

providing an inductor including a first terminal coupled to the third node and a second terminal coupled to ground;

selectively adjusting a first resistance of a first tunable resistor including a first terminal coupled to the third node and a second terminal coupled to ground;

selectively adjusting a first capacitance of a first tunable capacitor including a first terminal coupled to the third node and a second terminal coupled to ground;

selectively adjusting a second resistance of a second tunable resistor including a first terminal coupled to the third port and a second terminal coupled to ground; and

selectively adjusting a second capacitance of a second tunable capacitor including a first terminal coupled to the third port and a second terminal coupled to ground; and

wherein one or more of the first tunable resistor, the second tunable resistor, the first tunable capacitor, or the second tunable capacitor are selectively adjusted in response to receiving one or more control signals from a control circuit to adjust one or more of a phase or an attenuation of the second signal.

**FIG. 1A**

**FIG. 1B**

200

PROGRAMMABLE POWER DIVIDER/COMBINER
102

104
P1
POWER =
(N+1)P

IMPEDANCE
MATCHING
CIRCUIT
204

206

(N+1)P

N:1
UNEQUAL
WILKINSON
POWER
DIVIDER/
COMBINER
208

210
POWER =
N*P

214
POWER =
1*P

CONFIGURABLE IMPEDANCE
TRANSFORMATION CIRCUIT WITH PHASE
SHIFT AND ATTENUATION CONTROL
212(1)

106
P2
POWER =
N*P

CONFIGURABLE IMPEDANCE
TRANSFORMATION CIRCUIT WITH PHASE
SHIFT AND ATTENUATION CONTROL
212(2)

108
P3
POWER =
(1-ATT)*P

CONTROL
CIRCUIT
122

*FIG. 2*

300

UNEQUAL WILKINSON POWER DIVIDER/COMBINER 208

304(1) L$_{IN2}$

206

306

C$_{ISO}$

308

R$_{ISO}$

Z$_0$

C$_{IN}$

302 — 304(2) L$_{IN3}$

210

Z$_{P2}$

214

Z$_{P3}$

**FIG. 3A**

320

UNEQUAL WILKINSON POWER DIVIDER/COMBINER 208

304(1) L$_{IN2}$

206

308

R$_{ISO}$

Z$_0$

C$_{IN}$

302 — 304(2) L$_{IN3}$

C$_{ISO}$

306

210

Z$_{P2}$

Z$_{P3}$

214

**FIG. 3B**

400

UNEQUAL WILKINSON POWER DIVIDER/COMBINER 208

$Z_0$

$Z_{P2}$

$Z_{P3}$

404(1) $C_{IN2}$

206

$L_{IN}$

402

$C_{IN3}$

404(2)

406 $L_{ISO}$

308 $R_{ISO}$

210

214

## FIG. 4A

420

UNEQUAL WILKINSON POWER DIVIDER/COMBINER 208

$Z_0$

$Z_{P2}$

$Z_{P3}$

404(1) $C_{IN2}$

206

$L_{IN}$

402

$C_{IN3}$

404(2)

308 $R_{ISO}$

406 $L_{ISO}$

210

214

## FIG. 4B

*FIG. 5A*

*FIG. 5B*

*FIG. 5C*

FIG. 6

FIG. 7

FIG. 8

FIG. 9

1000

RECEIVE A SIGNAL AT AN INPUT TERMINAL OF A POWER DIVIDER/COMBINER CIRCUIT
1002

DIVIDE THE RECEIVED SIGNAL ACCORDING TO A SELECTED POWER DIVISION RATIO TO PRODUCE A FIRST SIGNAL AT A FIRST NODE AND A SECOND SIGNAL AT A SECOND NODE
1004

SELECTIVELY ADJUST ONE OR MORE OF A PHASE OR AN AMPLITUDE OF THE FIRST SIGNAL USING A FIRST CONFIGURABLE IMPEDANCE TRANSFORMATION CIRCUIT TO PRODUCE A FIRST OUTPUT SIGNAL
1006

SELECTIVELY ADJUST ONE OR MORE OF A PHASE OR AN AMPLITUDE OF THE SECOND SIGNAL USING A SECOND CONFIGURABLE IMPEDANCE TRANSFORMATION CIRCUIT TO PRODUCE A SECOND OUTPUT SIGNAL
1008

PROVIDE THE FIRST OUTPUT SIGNAL TO A FIRST OUTPUT NODE AND THE SECOND OUTPUT SIGNAL TO A SECOND OUTPUT NODE TO PROVIDE A SELECTED POWER DIVISION RATIO BETWEEN THE FIRST AND SECOND OUTPUT NODES
1010

*FIG. 10*

EP 4 704 340 A2

RECEIVE A FIRST SIGNAL AT A SECOND PORT AND A SECOND SIGNAL AT A THIRD PORT OF A POWER DIVIDER/COMBINER CIRCUIT
1102

SELECTIVELY ADJUST ONE OR MORE OF A PHASE OR AN AMPLITUDE OF THE FIRST SIGNAL USING A FIRST CONFIGURABLE IMPEDANCE TRANSFORMATION CIRCUIT TO PRODUCE A TRANSFORMED FIRST SIGNAL
1104

SELECTIVELY ADJUST ONE OR MORE OF A PHASE OR AN AMPLITUDE OF THE SECOND SIGNAL USING A SECOND CONFIGURABLE IMPEDANCE TRANSFORMATION CIRCUIT TO PRODUCE A TRANSFORMED SECOND SIGNAL
1106

COMBINE THE TRANSFORMED FIRST SIGNAL AND THE TRANSFORMED SECOND SIGNAL TO PRODUCE A COMBINED SIGNAL
1108

PROVIDE THE COMBINED SIGNAL TO A FIRST PORT OF THE POWER DIVIDER/COMBINER CIRCUIT
1110

*FIG. 11*

28